# EUROPEAN PATENT APPLICATION

(11) **EP 4 071 553 A1**
(43) Date of publication of application: **12.10.2022**
(21) Application number: 21167239.9
(22) Date of filing: 07.04.2021
(51) Int. Cl.: G03F 7/20

(54) **METHOD OF DETERMINING AT LEAST A TARGET LAYOUT AND ASSOCIATED METROLOGY APPARATUS**

(71) Applicant: ASML Netherlands B.V., 5500 AH Veldhoven (NL)
(72) Inventor: WERKMAN, Roy, 5500 AH Veldhoven (NL); WILDENBERG, Jochem, Sebastiaan, 5500 AH Veldhoven (NL); RIJPSTRA, Manouk, 5500 AH Veldhoven (NL)
(74) Representative: ASML Netherlands B.V.

(57) **Abstract**

Disclosed is a method of optimizing a target layout for a patterning device and a sampling scheme for measuring the targets of said target layout exposed on a substrate, the method comprising co-optimizing said target layout and said sampling scheme to obtain an optimized target layout for the patterning device and an optimized sampling scheme for measuring the targets of the optimized target layout exposed on a substrate..

## Description

### FIELD OF THE INVENTION

The present invention relates to methods and apparatus usable, for example, in the manufacture of devices by lithographic techniques, and to methods of manufacturing devices using lithographic techniques. The invention relates more particularly to metrology methods for measuring such devices as part of process control.

### BACKGROUND ART

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Due to time and throughput constraints and/or constraints on available reticle and/or wafer area, it may not be possible to measure sufficient targets for complete characterization of a parameter across a wafer and/or field. For example, there is a practical and/or economic limit to the number of alignment targets (alignment marks) which can be measured to define a control grid, this limit meaning that the characterization of the grid distortions cannot be completely captured and modelled (or not characterized as well as might be desirable where there no such practical/economic limit). There is a similar practical/economic limit on the number overlay targets or focus targets which may be measured to characterize an (interfield and/or intrafield) overlay fingerprint (spatial overlay distribution) or focus fingerprint (spatial focus distribution). The limit may be based on a speed/quality balance; e.g., a throughput impact may be taken in order to produce more yielding devices per unit of time. Ultimately it is profitability (good dies per unit time) which matters.

Due to this practical or economic limit, which results in a sensitivity of accuracy to target placement, it is desirable to optimize target placement (accommodation and/or position of targets on a reticle) and/or which targets are ultimately measured (sampling scheme optimization SSO).

### SUMMARY OF THE INVENTION

The invention in a first aspect provides A method of optimizing a target layout for a patterning device and a sampling scheme for measuring the targets of said target layout exposed on a substrate, the method comprising co-optimizing said target layout and said sampling scheme to obtain an optimized target layout for the patterning device and an optimized sampling scheme for measuring the targets of the optimized target layout exposed on a substrate..

Also disclosed is a computer program, processing device metrology apparatus and a lithographic apparatus comprising a metrology device being operable to perform the method of the first aspect.

The above and other aspects of the invention will be understood from a consideration of the examples described below.

### BRIEF DESCRIPTION OF THE DRAWINGS

Embodiments of the invention will now be described, by way of example only, with reference to the accompanying drawings, in which:
Figure 1 depicts a lithographic apparatus;
Figure 2 illustrates schematically measurement and exposure processes in the apparatus of Figure 1; and
Figure 3 is a flowchart describing a method according to an embodiment of the invention.

### DETAILED DESCRIPTION OF EMBODIMENTS

Before describing embodiments of the invention in detail, it is instructive to present an example environment in which embodiments of the present invention may be implemented.

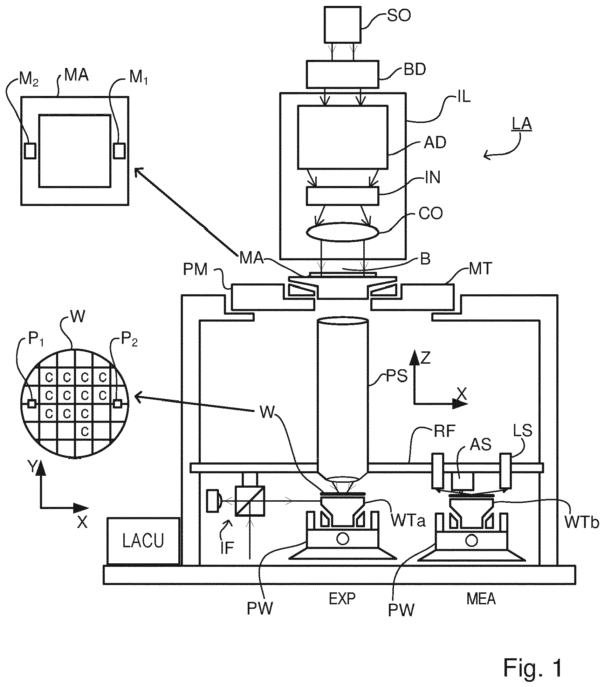

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks PI, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

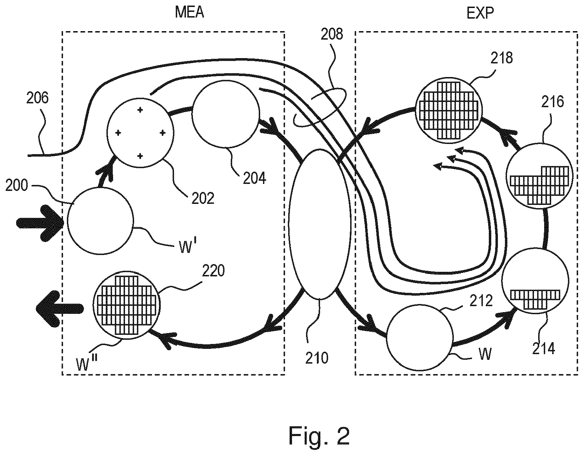

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks PI etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the position deviation from expected position of marks across the wafer, including any distortion relative to a nominal rectangular grid. Concepts disclosed herein are particular applicable to the definition of this wafer grid and the target arrangement/sampling scheme for defining the wafer grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters. These more advanced models are becoming increasingly common for alignment. Because of this, more alignment marks are needed on the wafer; however, because of throughput requirements there are limitations on the number of marks per wafer that can be measured. As such, the placement of marks and which of these marks are ultimately measured is of particular importance.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

One example of a metrology apparatus suitable for metrology in a lithographic monitoring context is a scatterometer. Scatterometers may comprise dark-field scatterometers (where the zeroth order is blocked before the detector such that only diffracted higher orders are captured) and bright-field scatterometers which also capture the zeroth order. Some scatterometers are capable of both bright-field and dark-field metrology. A known type of dark-field scatterometry technique compares the intensity of each of a pair of complementary higher diffraction orders (e.g., compares the respective intensities of the +1 and -1 orders) to determine asymmetry in the measured target (the magnitude of the intensity difference scales with the asymmetry. The target asymmetry can in turn be used to determine various parameters of interest such as overlay or the focus setting when the target was formed.

For both pre-exposure metrology context (e.g., alignment) and post-exposure metrology context (e.g., overlay metrology , focus metrology- i.e., the focus setting of the scanner during target formation, critical dimension CD metrology etc.), there is a practical limit in the number of targets which can be placed on a reticle (patterning device or mask) and where on the reticle, targets can be accommodated. These constraints will be dependent on, for example, the other features on the reticle (the reticle pattern), the metrology tool used to measure the targets (which puts limits or defines the target form and target size (e.g., minimum and/or maximum sizes)) and any model used to characterize the measurement data (e.g., intrafield model, interfield model, per-field model).

When a wafer is exposed using such a reticle, it is unlikely that all of the targets exposed on the wafer can be measured, as this would take too long and affect throughput. The reticle may often comprise more targets than can be measured in every field over the wafer. This is particularly important for inline metrology e.g., alignment and inline overlay/focus metrology, as speed is more critical for such inline metrology. As such, a "sampling scheme" may be determined, which defines which of the exposed targets (a subset of available targets) will be measured on the wafer. This may comprise measuring different targets for different fields across the wafer.

Presently, a two-stage approach is used for defining a measurement scheme, in that these two optimizations (reticle layout optimization and sampling scheme optimization) are performed separately. More specifically, the reticle layout is typically determined first to define the number of targets and their location on the reticle. Such an optimization may be based on a desired intrafield model, e.g., in accordance with an uncertainty metric such as normalized model uncertainty nMU (e.g., according to an intrafield model and/or per-field model). Optionally, other considerations may be taken into account, such as one or more of: defining a uniform field coverage (optimizing uniformity), defining a symmetric target layout (optimizing symmetry), defining an additional intrafield weighting e.g. to better cover the edge of each field and/or the wafer (e.g., as disclosed in US2018011398, which is hereby incorporated herein by reference).

Then, in a second stage, based on a given reticle layout (e.g., as defined in the first stage), a sampling scheme optimization may be performed to define the sampling scheme or wafer measurement layout. Such a sampling scheme optimization may optimize nMU (e.g., according to an interfield model and intrafield model (when also used for intrafield modeling) while optimizing uniformity of wafer coverage, for example. Other considerations may comprise maximizing imformativity of the sampling scheme (e.g., using the methods disclosed in WO2015110191, which is hereby incorporated herein by reference). This sampling scheme optimization may be co-optimized with capture and noise performance: i.e., which model best describes the wafer interfield fingerprint (across-wafer spatial representation of a parameter of interest) and intrafield fingerprint (across-field spatial representation of a parameter of interest) without introducing too much noise.

The disadvantage of the current method is that the two optimization steps are decoupled insofar as, while the wafer sampling scheme optimization is aware of the result of the reticle layout optimization (as it is required as an input to the sampling scheme optimization and may serve as an input candidate scheme), neither optimization step is aware of the entire optimization criteria of the other. This approach possibly leads to suboptimal measurement schemes. This may be particularly the case where the number of targets or marks on the reticle is limited (e.g., fewer than 20 or fewer than 16). Also, in addition to the limitation on the number of targets on a reticle, there is a limitation on the number of marks which can be accommodated on a wafer. For example, in an alignment context, each additional alignment mark on the reticle/wafer takes valuable space and therefore it is desirable to keep their number to a minimum. This reduces scope, as is presently done, in putting a larger number of alignment marks on the reticle for both interfield and intrafield modeling, thereby increasing optimization flexibility.

Another situation where wafer layout information is important during reticle layout creation, is for per-field modeling; e.g., of edge fields where only part of the fields can be measured. Small alterations of measurement positions and/or adding only one or two marks will have significant impact on how well the edge fields can be modeled. As such, intrafield data may comprise per-field data describing spatial variation of the parameter of interest across each exposure field or groups of exposure fields (e.g., grouped into two or more groups according to distance from wafer center such as edge fields versus center fields) individually.

To address these issues, it is proposed to co-optimize the reticle target layout and wafer sampling scheme(s) in a single optimization step. Alternatively, or in addition, a method of optimizing at least the reticle target layout based on interfield data (e.g., interfield fingerprint data) in addition to intrafield data (e.g., intrafield fingerprint data) and/or per-field fingerprint data is disclosed. Per-field fingerprint data may comprise intrafield fingerprints which vary from field-to-field (or per groups of fields).

There are two proposed main approaches for performing such a co-optimization. In a first main approach, the co-optimization may be performed according to *a priori* fingerprint knowledge. For example, in such an embodiment, the applicable models are known and the reticle layout and sampling scheme are co-optimized to capture these models. The applicable models may comprise: at least one interfield model and at least one intrafield model (where an intrafield model may comprise at least one per-field model). Where the fingerprint data is available per layer, such an approach may be performed per each specific layer to obtain co-optimized reticle layout and sampling scheme per layer.

A second main approach may comprise an *a posteriori* approach. Such an approach may comprise (e.g., in a calibration phase) exposing test wafers using a first test reticle with a dense target layout, and performing a dense readout of the test wafers. The dense readout data is used to analyze the fingerprints present. Based on these measured fingerprints and variation thereof, the reticle layout and sampling scheme may be co-optimized. Such an approach may be performed per each specific layer to obtain co-optimized reticle layout and sampling scheme per layer. Such a method may be processed or refined according to the data (i.e., data driven). For example, it may be preferred to use points with smaller measurement variation, and/or the optimization may be weighted in favor of such points.

In both of these two main approaches, the wafer and field layout information is inherently used in combination with the model knowledge. In this context, the wafer layout may describe how fields (e.g., edge fields) are positioned on the wafer and the field layout may describe (for example) the layout of dies and their number in each field, and the available sampling area (area in which targets may be accommodated; e.g., scribe lanes only, or also in-product). Another consideration my also be edge clearance which defines how close to the edge of the wafer measurements may be made (and as such may define an edge region in which targets will not be measured. Both of the wafer and field layout information determines the candidate positions: i.e., where targets/marks may be located.

In this manner, the co-optimization may be based on the interfield (and/or per-field) and the intrafield fingerprints, such that these different fingerprints are co-optimized for.

In addition to the wafer and field layout information, other considerations may be taken into account for the layout/sampling scheme co-optimization, such as those used presently. For example, such considerations may include one or more of (a)symmetry, uniformity and measurement routing.

For example, a spatially symmetric layout at a field and/or wafer level may be desired. Alternatively, an asymmetric layout may be preferred as this may lead to improved performance (e.g., to average out scanner moving average (MA) effects it may be preferred not to place targets at the same Y position).

In terms of uniformity, a more uniform layout may be more robust at averaging out non-captured fingerprint effects.

Optimized measurement routing may lead to lower measurement time, allowing additional measurements and/or higher wafer throughput. As such, the co-optimization may also co-optimize the measurement routing (i.e., the order in which the targets are sampled). This may be particularly suited to inline metrology.

It may be appreciated that the co-optimization may yield different types of target layouts and sampling schemes to provide greater flexibility. For example, instead of the co-optimization determining the reticle layout and a single sampling scheme only, the output may comprise a (e.g., dense) candidate sampling scheme which may be used as a support (e.g., for use in global wafer modeling and per-field modeling). More specifically, the support may be used for one or more of (e.g., in a separate additional optimization step):
- an optimized sparse sampling scheme.
- multiple optimized sparse sampling schemes, e.g., for hybrid sampling (e.g., dynamic or distributed sampling). Examples of distributed sampling methods are disclosed in, for example, US20140354969A1 or US20200371441A1 which are disclosed herein by reference. Briefly, distributed sampling distributes the sampling to capture a certain fingerprint over multiple wafers, such that the sampling scheme can vary for different wafers. As such, the dense candidate scheme may be optimized to describe particular interfield and intrafield fingerprints, with the scheme distributed over a number of wafers in the form of the multiple optimized sparse sampling schemes, each comprising a subset of the measurement locations of the dense scheme.
- a semi-dense sampling scheme (or the full dense candidate scheme), for optimal per-field modeling (e.g., corrections per exposure CPE), for example, focusing on edge field performance..

With regard to the co-optimization itself, in an embodiment, a proposed method may comprise performing a (e.g., dense) sampling scheme optimization based on a very dense intrafield mark layout under the constraint that only a limited number of unique locations (i.e., per-field or reticle locations) may ultimately be selected. Additionally the constraint may also limit the number of target locations which can be accommodated outside of one or more reticle and/or substrate areas (such as scribe lanes). For example, only a limited number of target may be accommodated outside of the scribe lanes (or other such designated substrate areas), or it may be that all targets are to be accommodated within scribe lanes.

Such an approach may use an evolutionary algorithm (e.g., a genetic algorithm) or a similar nature-inspired optimization algorithm (e.g. particle swarm, simulated annealing, etc.). WO2018/069015 (incorporated herein by reference) describes the use of such algorithms in sample scheme optimization. An evolutionary algorithm (EA) is a generic population-based metaheuristic optimization algorithm. A genetic algorithm (GA) is a type of EA. In a GA, a population of candidate solutions (called individuals, creatures, or phenotypes) to an optimization problem is evolved toward better solutions. Each candidate solution has a set of properties (its chromosomes or genotype), represented by a coordinate in the solution domain, which can be mutated and altered. Solutions may be represented in binary as strings of 0s and 1s, but other encodings are also possible. Simulated annealing (SA) is a probabilistic technique for approximating the global optimum of a given function. SA is a metaheuristic to approximate global optimization in a large search space or solution domain. Tabu search is another metaheuristic search method employing local search methods used for mathematical optimization.

Genetic algorithms maintain a pool of solutions rather than just one. New candidate solutions are generated not only by "mutation" (as in SA), but also by "recombination" of two solutions from the pool. Probabilistic criteria, similar to those used in SA, are used to select the candidates for duplication, mutation or combination (by cross-over), and for discarding excess solutions from the pool.

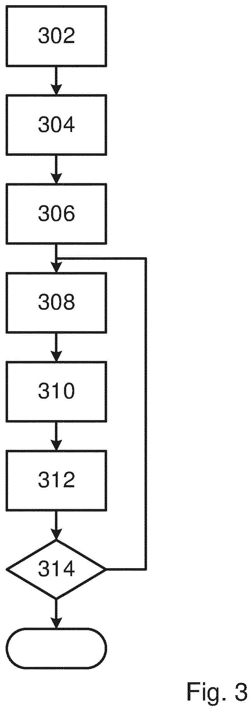

Figure 3 is a flowchart illustrating a method for co-optimizing a reticle target layout and sampling scheme according to an embodiment of the invention. The method may comprise the steps:
302: Defining constraints, and optionally cost function(s). The constraints may include a constraint on the number of unique locations in the ultimate sampling scheme (e.g., a constraint on the number of targets in the finalized reticle layout). In this manner, the sampling scheme and reticle layout are co-optimized. Other constraints may be associated with available positions for placement of features. For example, marks may only be allowed in scribe lanes or at the edge of the wafer. Other constraints may impose uniformity, symmetry or asymmetry, a minimum amount of measurements or features associated with a region on the substrate. The cost function may calculate the difference between a modelled fingerprint and measured data. The cost function may be used to give a value to an individual (candidate solution) to compare with other individuals (candidate solutions). Other methods for evaluating the candidate solutions is by determining an uncertainty metric value for each candidate solution, such as nMU.
304: Defining the search space. For example, the search space may be all available wafer target locations corresponding to an initial (e.g., very dense) intrafield target layout. This initial layout may comprise full set of measurement locations (i.e. all feasible locations on the reticle where a target may be placed). The search space may be the feasible set of candidate solutions that satisfy all constraints. The boundaries of the search space may be defined by the dimensions of a wafer.
306: Defining a first candidate solution comprising a first set of locations. The first candidate solution is a set of one or more locations, for example target or measurement locations, on a wafer. Each candidate solution can be defined by coordinates in the search space. The first candidate solution may be an individual in a population of candidate solutions. In that case the population is a first generation.

This first candidate solution may be based on generation of random or pseudo-random coordinates in the search space.

The first candidate solution may be based on knowledge of the constraint. This knowledge can include the layout and layers used to make the product, for example a specific integrated circuit. For example, a constraint could be one or more of: a constraint on the number of targets per field (on the reticle), a constraint on the number of targets per row; a constraint on the number of targets for each die; and a limit on real estate used by the marks Each constraint may impose a maximum and/or minimum value.

308: Defining a second candidate solution comprising a second set of locations in the search space, based on modification of a coordinate in the search space of the first candidate solution. Modification of the coordinate may involve one or more of the following operations: duplication; mutation; and cross-over. The second candidate solution may be an individual in a population of candidate solutions. In that case the population is a second generation, relative to the first candidate solution being in a first generation. Because there are many generations, first and second may refer to current and next, or previous and current.

310: Optionally, determine a value of a cost function associated with a required measurement accuracy or feature layout on the substrate.

312: Selecting the first and/or second candidate solution as the optimal solution according to a constraint associated with the substrate and/or according an uncertainty metric. Optionally, the selecting of the first and/or second candidate solution is further according to the (evaluated) value of the cost function.

314: If the constraint is satisfied and (optionally) the value of a cost function has converged or a threshold uncertainty metric reached, or if a number of iterations has been reached, then the iterations end, otherwise control is passed back to step 308 for another iteration. The output may be at least one optimized sampling scheme and an optimized reticle layout to implement the scheme.

The steps of the method may be performed according to an evolutionary approach, in which case the first and second candidate solutions are individuals in successive populations of candidate solutions. The steps of the method may be performed according to a simulated annealing approach, in which case the candidate solutions are states in a search space comprising the solution domain.

In an alternative embodiment, the co-optimization may comprise iterating on the reticle layout and sampling scheme steps. Such an approach may comprise iteratively adjusting the mark layout and the sampling schemes, in a turn-based game like strategy. Such an approach may be implemented using one or more generative adversarial networks (GANs).

In a GAN, two neural networks contest with each other in a game (in the form of a zero-sum game, where one agent's gain is another agent's loss). The two networks comprise a generative network which generates candidates while the discriminative network evaluates them. The contest operates in terms of data distributions. Typically, the generative network learns to map from a latent space to a data distribution of interest, while the discriminative network distinguishes candidates produced by the generator from the true data distribution. The generative network's training objective is to increase the error rate of the discriminative network (i.e., "fool" the discriminator network by producing novel candidates that the discriminator thinks are not synthesized (are part of the true data distribution)).

In this way, via learning, the generator tries to create solutions (in this case sample schemes) which the discriminator cannot distinguish from training data (e.g., some kind of ground truth). In a sense, the GAN tries to maximize classification error. The training data may comprise examples of 'good' sampling schemes to provide the ground truth. The GAN will then try (and learn) to generate solutions which are at least as good.

In a separate implementation, it is also possible to perform only a reticle layout optimization based on the interfield and/or per-field fingerprints in addition to the intrafield fingerprints. This leaves the actual sampling locations open, but with the candidate sampling locations pre-optimized.

The co-optimization may be applied, for example, to any situation where dedicated prior allocation of reticle real-estate is required; e.g., for placement of overlay target, focus target, CD target or alignment marks.

The co-optimization may be performed for each single control domain only; e.g., such that an alignment sampling scheme co-optimization is performed separately to an overlay sampling scheme co-optimization.

The terms "optimize", "optimizing" and "optimization" as used herein mean adjusting a lithographic process parameter such that results and/or processes of lithography have a more desirable characteristic, such as higher accuracy of projection of a design layout on a substrate, a larger process window, etc.

Further embodiments may be described in the following clauses:
1. A method of optimizing a target layout for a patterning device and a sampling scheme for measuring the targets of said target layout exposed on a substrate, the method comprising co-optimizing said target layout and said sampling scheme to obtain an optimized target layout for the patterning device and an optimized sampling scheme for measuring the targets of the optimized target layout exposed on a substrate.
2. A method according to clause 1, further comprising:
   obtaining substrate layout data describing a layout of fields across a substrate and field layout data describing a layout of features within the one or more exposure fields,
   wherein the step of co-optimizing said target layout and said sampling scheme is based on said substrate layout data and field layout data.
3. A method according to clause 1 or 2, further comprising:
   obtaining a model for describing spatial variation of a parameter of interest across a substrate, a field, and/or an average field,
   wherein the step of co-optimizing said target layout and said sampling scheme is based on the model.
4. A method according to clause 1 or 2, further comprising:
   obtaining measurement of spatial variation of a parameter of interest on one or more substrates,
   wherein the step of co-optimizing said target layout and said sampling scheme is based on the measurement.
5. A method according to clause 4, wherein the measurement are processed by weighting in favor of measurements with smaller associated measurement variation,
6. A method according to any of clauses 1 to 5, wherein said co-optimization step optimizes said target layout and said sampling scheme for interfield modeling according to an interfield model and for intrafield modeling according to an intrafield model.
7. A method according to clause 6, wherein said optimization step comprises a minimization of one or more model uncertainty metrics relating to said interfield model and said intrafield model.
8. A method according to any of clauses 1 to 7, the method further comprising the step of obtaining intrafield data describing spatial variation of the parameter of interest across one or more exposure fields of the substrate,
   wherein said intrafield data comprises per-field data describing spatial variation of the parameter of interest across each exposure field or groups of exposure fields individually.
9. A method according to clause 8, wherein said co-optimization step optimizes said target layout and at least one sampling scheme for per-field intrafield modeling according to at least one per-field intrafield model.
10. A method according to any of clauses 1 to 9, wherein said co-optimization additionally optimizes for one or more of:
   symmetry or asymmetry in the target layout and/or the sampling scheme,
   uniformity in coverage of the target layout and/or the sampling scheme, and measurement routing over the sampling scheme.
11. A method according to any of clauses 1 to 10, wherein said co-optimization step is an iterative step comprising iterations of sequential adjustment of said target layout and said sampling scheme.
12. A method according to clause 11, wherein said co-optimization step uses a generative adversarial network or other turn-based game algorithm.
13. A method according to any of clauses 1 to 10, wherein said co-optimization comprises a sampling scheme optimization based on a very dense intrafield target layout under the constraint that only a limited number of unique target locations may be comprised within the sampling scheme.
14. A method according to clause 13, wherein said constraint also limits the number of target locations which can be accommodated outside of one or more reticle and/or substrate areas.
15. A method according to clause 14, wherein said the number of target locations which can be accommodated outside of said one or more reticle and/or substrate areas is zero.
16. A method according to any of clauses 13 to 15, wherein said co-optimization uses one or more of a genetic algorithm, other evolutionary algorithm, a particle swarm algorithm and a simulated annealing algorithm.
17. A method according to any of clauses 1 to 16, wherein said co-optimization step yields said target layout and a candidate sampling scheme for use as a support for one or more of:
   an optimized sparse sampling scheme, comprising a proper subset of the measurement locations defined by said candidate sampling scheme;
   a plurality of optimized sparse sampling schemes each comprising a proper subset of the measurement locations defined by said candidate sampling scheme.
   a semi-dense sampling scheme comprising a proper subset of the measurement locations defined by said candidate sampling scheme, or said candidate sampling scheme, for per-field modeling.
18. A method according to clause 17, wherein said candidate sampling scheme is used as a support for said plurality of optimized sparse sampling schemes, and said a plurality of optimized sparse sampling schemes together define a distributed sampling scheme, distributed over a plurality of substrates.
19. A method of determining a target layout for a patterning device, the method comprising:
   obtaining interfield data describing spatial variation of a parameter of interest across a substrate;
   obtaining intrafield data describing spatial variation of the parameter of interest across one or more exposure fields of the substrate;
   obtaining substrate layout data describing a layout of fields across a substrate and field layout data describing a layout of features within the one or more exposure fields; and
   optimizing said target layout in terms of said interfield data and intrafield data based on said substrate layout data and field layout data to obtain an optimized target layout for the patterning device.
20. A method according to any preceding clauses, wherein said field layout data describes one or more of: the layout of dies and their number in each exposure field, and the available sampling area in which targets may be accommodated.
21. A method according to any preceding clauses, wherein said target layout relates to targets for the measurement of:
   overlay,
   focus,
   critical dimension, or
   alignment.
22. A computer program comprising program instructions operable to perform the method according to any preceding clauses, when run on a suitable apparatus.
23. A non-transient computer program carrier comprising the computer program of clause 22.
24. A processing arrangement comprising:
   the non-transient computer program carrier of clause 23; and
   a processor operable to run said computer program.
25. A metrology device comprising the processing arrangement of clause 24.
26. A lithographic manufacturing system comprising:
   at least one metrology device of clause 25; and
   a lithographic exposure apparatus.
27. A lithographic manufacturing system according to clause 26, where said at least one metrology device is an alignment sensor comprised within said lithographic exposure apparatus.
28. A lithographic manufacturing system according to clause 26 or 27, where said at least one metrology device comprises a post-exposure metrology device for performing post-exposure metrology.

While specific embodiments of the invention have been described above, it will be appreciated that the invention may be practiced otherwise than as described.

Any reference to a mark or target may refer to dedicated marks or targets formed for the specific purpose of metrology or any other structure (e.g., which comprises sufficient repetition or periodicity) which can be measured using techniques disclosed herein. Such targets may include product structure of sufficient periodicity such that alignment or overlay (for example) metrology may be performed thereon.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

## Claims

1. A method of optimizing a target layout for a patterning device and a sampling scheme for measuring the targets of said target layout exposed on a substrate, the method comprising co-optimizing said target layout and said sampling scheme to obtain an optimized target layout for the patterning device and an optimized sampling scheme for measuring the targets of the optimized target layout exposed on a substrate.

2. A method as claimed in claim 1, further comprising:
obtaining substrate layout data describing a layout of fields across a substrate and field layout data describing a layout of features within the one or more exposure fields,
wherein the step of co-optimizing said target layout and said sampling scheme is based on said substrate layout data and field layout data.

3. A method as claimed in claim 1 or 2, further comprising:
obtaining measurement of spatial variation of a parameter of interest on one or more substrates,
wherein the step of co-optimizing said target layout and said sampling scheme is based on the measurement.

4. A method as claimed in claim 3, wherein the measurement are processed by weighting in favor of measurements with smaller associated measurement variation.

5. A method as claimed in any of claims 1 to 4, wherein said co-optimization step optimizes said target layout and said sampling scheme for interfield modeling according to an interfield model and for intrafield modeling according to an intrafield model.

6. A method as claimed in claim 5, wherein said optimization step comprises a minimization of one or more model uncertainty metrics relating to said interfield model and said intrafield model.

7. A method as claimed in any of claims 1 to 6, the method further comprising the step of obtaining intrafield data describing spatial variation of the parameter of interest across one or more exposure fields of the substrate,
wherein said intrafield data comprises per-field data describing spatial variation of the parameter of interest across each exposure field or groups of exposure fields individually.

8. A method as claimed in claim 7, wherein said co-optimization step optimizes said target layout and at least one sampling scheme for per-field intrafield modeling according to at least one per-field intrafield model.

9. A method as claimed in any of claims 1 to 8, wherein said co-optimization additionally optimizes for one or more of:
symmetry or asymmetry in the target layout and/or the sampling scheme,
uniformity in coverage of the target layout and/or the sampling scheme, and
measurement routing over the sampling scheme.

10. A method as claimed in any of claims 1 to 9, wherein said co-optimization step is an iterative step comprising iterations of sequential adjustment of said target layout and said sampling scheme.

11. A method as claimed in claim 10, wherein said co-optimization step uses a generative adversarial network or other turn-based game algorithm.

12. A method as claimed in any of claims 1 to 11, wherein said co-optimization step yields said target layout and a candidate sampling scheme for use as a support for one or more of:
an optimized sparse sampling scheme, comprising a proper subset of the measurement locations defined by said candidate sampling scheme;
a plurality of optimized sparse sampling schemes each comprising a proper subset of the measurement locations defined by said candidate sampling scheme.
a semi-dense sampling scheme comprising a proper subset of the measurement locations defined by said candidate sampling scheme, or said candidate sampling scheme, for per-field modeling.

13. A method as claimed in claim 12, wherein said candidate sampling scheme is used as a support for said plurality of optimized sparse sampling schemes, and said a plurality of optimized sparse sampling schemes together define a distributed sampling scheme, distributed over a plurality of substrates.

14. A method as claimed in any preceding claim, wherein said field layout data describes one or more of: the layout of dies and their number in each exposure field, and the available sampling area in which targets may be accommodated.

15. A method as claimed in any preceding claim, wherein said target layout relates to targets for the measurement of:
overlay,
focus,
critical dimension, or
alignment.
